# EUROPEAN PATENT SPECIFICATION

(11) **EP 0 456 311 B1**
(45) Date of publication and mention of the grant of the patent: **15.01.1997**
(21) Application number: 91201050.1
(22) Date of filing: 03.05.1991
(51) Int. Cl.: H03K 19/0185, G02F 1/133, G09G 3/36

(54) **Quasi-static level shifter**
Quasi-statischer Pegelumsetzer
Convertisseur de niveau quasi-statique

(30) Priority: 07.05.1990 EP 90201157
(43) Date of publication of application: 13.11.1991
(73) Proprietor: Philips Electronics N.V., 5621 BA Eindhoven (NL); FASELEC A.G., Zürich 3 (CH)
(72) Inventor: Mühlemann, Kurt, NL-5656 AA Eindhoven (NL)
(74) Representative: Schouten, Marcus Maria

(56) References cited:
- US-A- 4 064 405
- US-A- 4 384 287
- US-A- 4 831 280
- PATENT ABSTRACTS OF JAPAN vol. 13, no. 243 (E- 768)(3591), 7 June 1989; & JP - A - 144619
- IEEE TRANSACTIONS ON ELECTRON DEVICES vol. ED-26, no. 5, May 1979,
- pages 802-806; J.C. ERSKINE et al.: "A Thin-Film-Transistor-Controlled Liquid- Crystal Numeric Display"

## Description

The invention relates to a level shifter, comprising a charging path between a first supply voltage and an output, and a discharging path between the output and a second supply voltage, the paths being controllable in a mutually complementary fashion by an input signal on an input, one of the paths being DC coupled to the input while the other path is coupled thereto *via* a capacitance, and also comprising a driver circuit which includes such level shifters and a display provided with such a driver circuit.

A level shifter of this kind is known *per se.* The operation of the known level shifter is fully dynamic, *i.e.* its output signal is not available in static form. Driving of further circuits by means of this output signal requires either a time-critical behaviour of these circuits or special steps to safeguard control of these circuits because at least one of the levels of this output signal is not stable. Therefore, it is an object of the invention to provide a level shifter of the kind set forth which does not have said drawbacks.

This object is achieved by a level shifter in accordance with the invention which is characterized in that in order to regenerate a control voltage on a control input of the other path, the input signal is logically combined With a recurrent signal in order to form a combined signal which is applied to the control input *via* the capacitance. The signal transferred *via* the capacitance, on the gate electrode is then continuously regenerated by a recurrent signal. The logic combination with the input signal ensures that the level shifter behaves as a static level shifter on the output, *i.e.* both logic levels on the output are substantially constant.

In the context of the present Patent Application a recurrent signal is to be understood to mean not only a signal which recurs after a regular time interval, but also a signal which recurs after an irregular time interval and/or with a deviating waveform.

In comparison with static level shifters, the level shifter in accordance with the invention also requires less surface area. Moreover, the power consumption of the level shifter in accordance with the invention is substantially lower.

The level shifter is preferably used in a driver circuit for controlling the row-wise and column-wise arranged display elements of a display, for example an LCD display. A plurality of level shifters can then be advantageously combined so that a number of components can be used in common in a number of level shifters. For example, a spike generator can then apply the same recurrent signal to several level shifters simultaneously. Such common use results in a substantial further reduction of the surface area required.

It is to be noted that the level shifter and driver circuits in accordance with the invention can be realised on a semiconductor substrate or also according to the so-called thin-film technique. In this respect reference is made to the article by J.C. Erskine and P.A. Snopko "A thin-film-transistor-controlled liquid-crystal numeric display", IEEE TED 26 (5), 1979, pp. 802-806. Thin-film integrated circuits can be advantageously used for display applications where the circuits are integrated in a thin film on a substrate, for example a glass plate or a quartz plate. The substrate then forms part of the screen of the (LCD) display. It will be evident that a higher degree of system integration can thus be achieved.

The invention will be described in detail hereinafter with reference to a drawing; therein:
Fig. 1 shows an example of a dynamic level shifter,
Fig. 2 shows an example of a level shifter in accordance with the invention,
Fig. 3 shows the voltages at various points in the circuit shown in Fig. 2, and
Fig. 4 shows an array of level shifters in accordance with the invention which use parts in common.

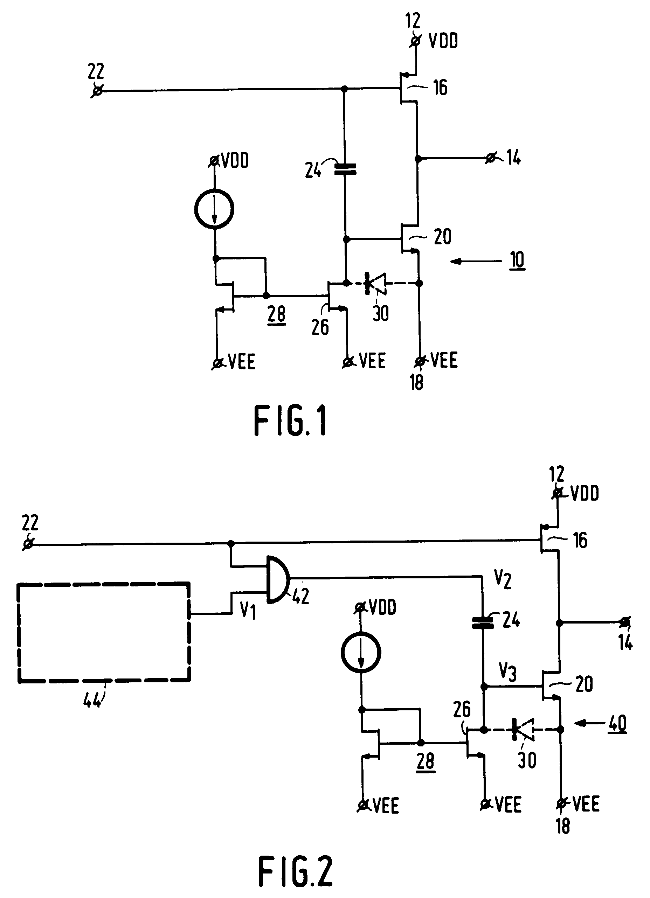

Fig. 1 shows a dynamic level shifter 10 which is integrated on a semiconductor substrate in the present example. The level shifter 10 comprises a P-channel transistor 16 between a first supply terminal 12 and the output 14 and an N-channel transistor 20 between the output 14 and a second supply terminal 18. The supply voltage on the terminal 12 is, for example 5 V and that on the terminal 18 is, for example minus 30 V. The input 22 receives input signals whose level (for example, 0-5 V) is transformed by the level shifter 10. The input 22 is directly connected to the gate of the transistor 16 and the capacitance 24 realises a capacitive coupling between the input 22 and the gate of the transistor 20. There is also provided a control discharging path for the gate of the transistor 20 which in this case comprises the output branch 26 of a current mirror 28. The control discharging path ensures that an accumulation of charge on the gate of the transistor 20, caused by a positive signal transition on the input 22, flows to the terminal 18. On the other hand, the PN-junction 30, being inherent of a P-well technology, provides equalization in the case of a negative signal transition on the input 22. The control discharging path as well as said PN-junction prevent a floating potential on the gate. It is a drawback of this circuit that the lowest level of the output signal on the output 14 does not have a fixed value, because the transistor 20 is turned on only during and briefly after a positive transition of the input signal. The circuits controlled by the output signal thus have to respond only briefly to the negative transition of the output signal or buffering is required at the input side.

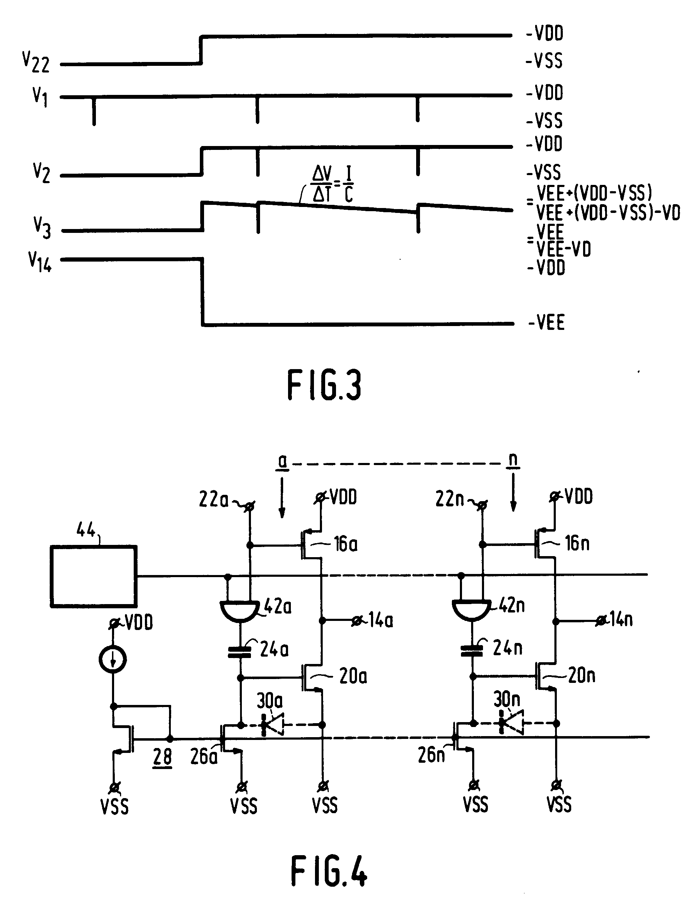

Fig. 2 shows an embodiment of a level shifter 40 in accordance with the invention which does not have said drawbacks. The reference numerals corresponding to those used in Fig. 1 denote similar or identical components. Instead of the direct capacitive coupling of the input 22 to the gate of the N-channel transistor 20, the input signal is first combined with a spike-shaped recurrent signal in the logic gate 42 whose input side is connected to the input 22 and to a spike generator 44. The signals present at various points in the circuit are shown in Fig. 3. The upper line V₂₂ represents the input signal on the input 22. The second line V₁ represents the spike-shaped recurrent output signal of the spike generator 44; the line V₂ therebelow represents the signal combined in the logic gate 42 which is subjected to the capacitance 24. V₃ represents the signal filtered by the capacitance 24 and present on the gate of the transistor 20, and the line 14 represents the output signal of the level shifter on the output 14. As a result of the combination operation, the voltage on the gate of the transistor 20 is periodically regenerated. This means that the logic high level of this voltage remains defined within a given range and hence also the low level of the output signal V₁₄.

Instead of a spike-shaped signal, a signal having an arbitrary waveform can be used when this signal is recurrently applied to the logic gate 42 during a short period of time.

Fig. 4 shows an embodiment comprising a plurality of n level shifters in accordance with the invention, the spike generator 44 as well as the input branch of the current mirror 28 being shared by a plurality of level shifters a ... n. This embodiment offers the advantage that the surface area required and also the current consumption are reduced. In this Figure each of the elements of the level shifters a ... n is denoted by the same reference numeral as used in Fig. 2, supplemented by one of the letters a ... n.

It is to be noted that the described embodiments relate to combined control of the N-channel transistor. A similar arrangement in the complementary case, *i.e.* in the case of capacitive control of the P-channel transistor, can be controlled in a similar manner.

It is also to be noted that the same principle can also be used, for example in the case of a push-pull stage consisting of two N-channel transistors.

Finally it is to be noted that instead of a current mirror as used in the abovepreferred embodiment, other control input discharging paths can be used, such as a diode, for example a high-ohmic poly-diode, a resistor, a parallel connection of a resistor and a diode.

## Claims

1. A level shifter (40) comprising a charging path (16) between a first supply voltage (VDD) and an output (14), and a discharging path (20) between the output and a second supply voltage (VEE) the paths being controllable in a mutually complementary fashion by an input signal (V₂₂) on an input, one of the paths being dc coupled to the input while the other path is coupled thereto *via* a capacitance (24), characterized in that in order to regenerate a control voltage (V₃) on a control input of the other path, the input signal is logically combined with a recurrent signal (V₁) in order to form a combined signal (V₂) which is applied to the control input *via* the capacitance.

2. A level shifter as claimed in Claim 1, characterized in that the level shifter comprises a spike generator (44) for generating a recurrent pulse signal as said recurrent signal and a logic gate (42) for combining the pulse signal with the input signal.

3. A level shifter as claimed in Claim 1, comprising an output branch (26) of a current mirror (28) arranged in a further discharging path for the control input, which extends between the control input and the second supply voltage.

4. A driver circuit comprising at least one level shifter as claimed in Claim 1, 2 or 3.

5. A driver circuit as claimed in Claim 4, comprising a plurality of level shifters, at least one of the following components being used in common for said plurality:
- a spike generator (44) for generating the recurrent signal;
- an input branch of a current mirror (28), a respective output branch of which is connected in a further discharging path between the control input of a relevant other path and the second supply voltage.

6. A driver circuit as claimed in Claim 4 or 5 which is integrated on a semiconductor substrate.

7. A display comprising a matrix of picture elements which are arranged in rows and columns and provided with a driver circuit as claimed in Claim 4 or 5 for controlling at least the rows or the columns.

8. A display as claimed in Claim 7, provided on a substrate, for example a glass plate or a quartz plate, the driver circuit being integrated at least partly on the substrate.

9. A data display arrangement comprising a display as claimed in Claim 7 or 8.

## Patentansprüche

1. Pegelumsetzer (40) mit einem Aufladepfad (16) zwischen einer ersten Versorgungsspannung (VDD) und einem Ausgang (14) und mit einem Entladepfad (20) zwischen dem Ausgang und einer zweiten Versorgungsspannung (VEE), wobei die Pfade von einem Eingangssignal (V22) an einem Eingang zueinander komplementär steuerbar sind, und wobei einer der Pfade gleichstrommäßig mit dem Eingang gekoppelt ist, während der andere Pfad über eine Kapazität damit gekoppelt ist, dadurch gekennzeichnet, daß zum Auffrischen einer Steuerspannung (V₃) an einem Steuereingang des anderen Pfades das Eingangssignal mit einem sich wiederholenden Signal logisch verknüpft ist, um ein kombiniertes Signal (V₂) zu bilden, das dem Steuereingang über die Kapazität zugeführt wird.

2. Pegelumsetzer nach Anspruch 1, dadurch gekennzeichnet, daß der Pegelumsetzer einen Spike-Generator (44) umfaßt zum Erzeugen eines sich wiederholenden Impulssignals als das sich wiederholende Signal und ein Logikgatter (42) zum Verknüpfen des Impulssignals mit dem Eingangssignal.

3. Pegelumsetzer nach Anspruch 1, mit einem Ausgangszweig (26) eines in einem weiteren Entladepfad für den Steuereingang angeordneten Stromspiegels (28), der zwischen dem Steuereingang und der zweiten Versorgungsspannung verläuft.

4. Treiberschaltung mit wenigstens einem Pegelumsetzer nach Anspruch 1, 2 oder 3.

5. Treiberschaltung nach Anspruch 4 mit einer Vielzahl von Pegelumsetzern, wobei wenigstens eine der folgenden Komponenten gemeinsam für diese Vielzahl verwendet wird:
- ein Spike-Generator (44) zum Erzeugen des sich wiederholenden Signals;
- ein Eingangszweig eines Stromspiegels (28), von dem je ein Ausgangszweig in einem weiteren Entladepfad zwischen dem Steuereingang eines betreffenden anderen Pfades und der zweiten Versorgungsspannung angeordnet ist.

6. Treiberschaltung nach Anspruch 4 oder 5, die auf einem Halbleitersubstrat integriert ist.

7. Display mit einer Matrix aus Bildelementen, die in Zeilen und Spalten angeordnet sind und mit einer Treiberschaltung nach Anspruch 4 oder 5 zum Steuern wenigstens der Zeilen oder der Spalten versehen sind.

8. Display nach Anspruch 7, auf einem Substrat, beispielsweise einer Glasplatte oder einer Quarzplatte, wobei die Treiberschaltung wenigstens teilweise auf dem Substrat integriert worden ist.

9. Datenwiedergabeanordnung mit einem Display nach Anspruch 7 oder 8.

## Revendications

1. Convertisseur de niveau (40) comprenant un trajet de charge (16) entre une première tension d'alimentation (VDD) et une sortie (14), et un trajet de décharge (20) entre la sortie et une deuxième tension d'alimentation (VEE), les trajets pouvant être commandés de manière mutuellement complémentaire par un signal d'entrée (V₂₂) à une entrée, l'un des trajets étant couplé en CC à l'entrée tandis que l'autre trajet est couplé via une capacité (24), caractérisé en ce que, pour régénérer une tension de commande (V₃) à une entrée de commande de l'autre trajet, le signal d'entrée est combiné de manière logique avec un signal récurrent (V₁) de manière à former un signal combiné (V₂) qui est appliqué à l'entrée de commande via la capacité.

2. Convertisseur de niveau selon la revendication 1, caractérisé en ce que le convertisseur de niveau comprend un générateur de pointes (44) pour générer un signal d'impulsion récurrent en tant que le dit signal récurrent et une porte logique (42) pour combiner le signal d'impulsion avec le signal d'entrée.

3. Convertisseur de niveau selon la revendication 1, comprenant une branche de sortie (26) d'un miroir de courant (28) agencé dans un autre trajet de décharge pour l'entrée de commande, qui s'étend entre l'entrée de commande et la deuxième tension d'alimentation.

4. Circuit d'excitation comprenant au moins un convertisseur de niveau selon la revendication 1, 2 ou 3.

5. Circuit d'excitation selon la revendication 4, comprenant une pluralité de convertisseurs de niveau, au moins l'un des composants suivants étant utilisé en commun pour ladite pluralité :
- un générateur de pointes (44) pour générer le signal récurrent, et
- une branche d'entrée d'un miroir de courant (28), dont une branche de sortie respective est connectée, dans un autre trajet de décharge, entre l'entrée de commande d'un autre trajet associé et la deuxième tension d'alimentation.

6. Circuit d'excitation selon la revendication 4 ou 5, qui est intégré sur un substrat semi-conducteur.

7. Affichage comprenant une matrice d'éléments d'image, qui sont agencés en rangées et en colonnes, ledit affichage étant pourvu d'un circuit d'excitation selon la revendication 4 ou 5 pour commander au moins les rangées ou les colonnes.

8. Affichage selon la revendication 7, prévu sur un substrat, par exemple une plaque de verre ou une plaque de quartz, le circuit d'excitation étant intégré au moins partiellement sur le substrat.

9. Dispositif d'affichage de données comprenant un affichage selon la revendication 7 ou 8.
